# DEMANDE DE BREVET EUROPEEN

(11) **EP 2 581 794 A1**
(43) Date de publication de la demande: **17.04.2013**
(21) Numéro de dépôt: 11185240.6
(22) Date de dépôt: 14.10.2011
(51) Int. Cl.: G04B 1/14, G04B 15/14, G04B 31/004, G04B 13/02

(54) **Ensemble fonctionnel de micromécanique**

(71) Demandeur: The Swatch Group Research and Development Ltd., 2074 Marin (CH)
(72) Inventeur: Richard, David, 1400 Yverdon-les-Bains (CH); Bourban, Stewes, 1589 Chabrey (CH)
(74) Mandataire: Ravenel, Thierry Gérard Louis

(57) **Abrégé**

L'invention concerne un ensemble fonctionnel (100) de micromécanique comprenant au moins une première pièce (10), ayant une première couche définissant une première surface de contact destinée à venir en contact de frottement avec une deuxième surface de contact définie par une deuxième couche ladite deuxième couche appartenant, soit à ladite première pièce (10) soit à au moins une deuxième pièce de micromécanique (20) constituant avec ladite première pièce (10) ledit ensemble (100) caractérisé en ce que les première et deuxième couches comportent chacune du carbone à hauteur d'au moins 50% d'atomes de carbone et en ce qu'elles présentent au niveau des première et deuxième surfaces de contact des orientations de plans cristallins en surface différentes l'une de l'autre.

## Description

### DOMAINE TECHNIQUE DE L'INVENTION

La présente invention concerne un ensemble fonctionnel de micromécanique comprenant une première pièce comprenant une première couche définissant une première surface de contact destinée à venir en contact de frottement avec une deuxième surface de contact définie par une deuxième couche ladite deuxième couche appartenant, soit à ladite première pièce, soit à au moins une deuxième pièce de micromécanique constituant avec ladite première pièce ledit ensemble. Elle concerne plus particulièrement un couple de pièces micromécaniques horlogères coopérant mécaniquement l'une avec l'autre telles qu'une roue d'échappement et des palettes d'ancre.

### ETAT DE LA TECHNIQUE ANTERIEURE

Les récentes constructions de mouvements horlogers mécaniques avec un échappement silicium revêtu de diamant (palettes et roue d'échappement), et sans lubrification liquide volontaire du contact palette/roue d'échappement ne fonctionnent pas de manière satisfaisante. En effet le pouvoir réglant d'un tel échappement non lubrifié est inférieur à ceux des dispositifs d'échappement comprenant une lubrification conventionnelle. La demanderesse a constaté dans certains cas que l'échappement non lubrifié cessait de fonctionner après quelques heures suite à une dégradation irréversible des performances tribologiques des revêtements de l'échappement.

La seule approche d'échappement revêtu de diamant non lubrifiée qui semble efficace consiste à polir préalablement les surfaces de frottement en diamant avant leur montage dans le mouvement horloger. Cela est toutefois laborieux et incompatible avec les exigences d'une fabrication industrielle avec un prix de revient acceptable.

Dans les applications micromécaniques, la plupart des couches diamant utilisées sont de nature nanocristalline (taille de grains <50nm, Ra<50nm) car intuitivement, l'homme du métier croit que plus les surfaces sont lisses, mieux elles frottent les unes sur les autres.

Le but principal de la présente invention est de fournir une solution tribologique permettant de faire frotter des composants micromécaniques sans lubrification de manière fiable et durable notamment dans des applications horlogères et qui pallie au moins les inconvénients de l'art antérieur mentionnés plus haut.

L'invention a également pour objet de fournir un ensemble fonctionnel de micromécanique, en particulier horloger, comportant des éléments mobiles avec des caractéristiques tribologiques améliorées qui ne nécessitent pas d'étapes de post traitement tel qu'un polissage.

### EXPOSE DE L'INVENTION

A cet effet l'invention concerne un ensemble fonctionnel de micromécanique comprenant au moins une première pièce comprenant une première couche définissant une première surface de contact destinée à venir en contact de frottement avec une deuxième surface de contact définie par une deuxième couche ladite deuxième couche appartenant, soit à ladite première pièce soit à au moins une deuxième pièce de micromécanique constituant avec ladite première pièce ledit ensemble, ce dernier étant caractérisé en ce que les première et deuxième couches sont formées chacune de carbone à hauteur d'au moins 50% d'atomes de carbone, et en ce qu'elles présentent au moins au niveau des première et deuxième surfaces de contact des orientations de plans cristallins en surface différentes l'une de l'autre.

Grâce à un tel agencement, il est possible de faire fonctionner un couple de pièces micromécaniques, comme par exemple le couple palettes d'ancre/roue d'échappement d'un mouvement horloger sans lubrification. La demanderesse a constaté que les performances tribologiques d'un tel ensemble fonctionnel dans cette application sont aussi bonnes voire meilleures que celles des échappements de l'état de l'art avec lubrification liquide.

Les première et deuxième couches de la ou desdites pièces micromécaniques agencées selon une telle configuration présentent une plus grande résistance à l'usure. Par ailleurs, les pertes énergétiques dues aux frottements entre deux surfaces de contact des couches sont fortement réduites de sorte que l'ensemble fonctionnel de micromécanique présente ainsi de meilleures caractéristiques tribologiques par rapport à des couples de surfaces de frottement antagonistes de même structure. Le phénomène résultant de la mise en frottement de surfaces de structure identique, couramment désigné par le terme anglais « interlocking », est supprimé par l'agencement de la présente invention. Selon un mode de réalisation avantageux de l'invention, au moins ladite première couche présente au moins au niveau de sa surface de contact une structure microcristalline, et de préférence lesdites première et deuxième couches présentent au moins au niveau de leur surface de contact chacune une structure microcristalline. Typiquement, la taille des grains desdites première et/ou deuxième couches au moins au niveau de leur surface de contact respective est supérieure à 200nm et inférieure à 10 micromètres.

Selon une variante préférée de ce mode de réalisation, les plans cristallins desdites première et/ou deuxième couches présentent au moins au niveau de leur surface de contact respective chacune des orientations différentes selon des directions prédéterminées, et par exemple faisant intervenir la direction [100] de la famille des directions <100> ou la direction [111] de la famille des directions <111>.

De préférence, on associera un des plans cristallins de la famille des plans cristallins {100} de ladite première couche au moins au niveau de la première surface de contact et un des plans cristallins de la famille des plans cristallins {111} de ladite deuxième couche au moins au niveau de la deuxième surface de contact.

Selon une caractéristique avantageuse, l'angle moyen défini par les normales aux plans cristallins (100) de la famille {100} et (111) de la famille {111} des couches au moins au niveau de leur surface de contact respective est compris entre 10° et 70°, de préférence entre 40 ° et 50°, et plus préférentiellement de 45°.

Selon un mode de réalisation avantageux la première pièce est réalisée en diamant massif mono ou polycristallin.

De préférence, la rugosité moyenne (Rms) d'une des première ou deuxième surfaces de contact est comprise entre 80 nm et 3 micromètres. La rugosité moyenne de l'autre des première ou deuxième surface de contact est plus faible et de préférence au moins une fois et demi plus faible, typiquement comprise entre 50 nm et 2 micromètres.

Selon une variante de réalisation de l'invention, ladite première et/ou deuxième couche de frottement définissant ladite première surface de contact et/ou ladite deuxième surface de contact recouvre un premier et/ou un deuxième substrat pour former ladite première et/ou ladite deuxième pièce. Typiquement le premier et/ou le deuxième substrat peut être en silicium ou en acier ou en céramique, avec ou sans couche intermédiaire de type chrome, titane, nickel, etc.. Dans le cas d'un substrat en silicium, ce dernier peut être nitruré, carburé, oxydé ou brut.

Selon une autre variante, la première et/ou la deuxième pièce sont réalisées en diamant massif mono ou polycristallin définissant ainsi directement les première et/ou deuxième surfaces de contact. Que ladite première et/ou ladite deuxième couche soient déposées sur un substrat ou massive, l'épaisseur de ces couches est au moins supérieure à 150nm. Pour des pièces massives, l'épaisseur de la première couche peut atteindre jusqu'à 1mm. Pour des pièces avec substrat, la première et/ou deuxième couche déposée peut atteindre jusqu'à 50 micromètres d'épaisseur.

L'ensemble fonctionnel de micromécanique de la présente invention trouve des applications avantageuses dans le domaine de l'horlogerie. En particulier, la première pièce peut être une palette et la deuxième pièce une roue d'échappement ou inversement. Dans une autre application horlogère, la première pièce peut être un axe d'un mobile et la deuxième pièce un palier ou inversement. Selon une autre application de ce domaine, les première et deuxième pièces peuvent être des dentures de roues d'engrenage. Dans un tel couple d'éléments, les surfaces de contact des pièces en contact de frottement ne subissent pas de dégradation irréversible de leurs performances tribologiques et présentent une bonne stabilité. Il est possible de prévoir un fonctionnement d'un système mobile horloger, tel qu'un échappement à ancre suisse sans lubrification du contact palette/roue d'échappement, avec des performances au moins équivalentes aux références standard. Les couches de frottement (massive ou sur substrat) de la présente invention, notamment de diamant, sont immédiatement performantes, sans avoir à modifier par post-traitement la nature des surfaces de frottement (par exemple par polissage, terminaison de surface, etc.). Dans une application horlogère n'impliquant qu'une seule pièce selon l'invention, celle-ci peut être un ressort de barillet formée d'une lame, une face avant de ladite lame formant ladite première surface de contact, et la face arrière de ladite lame formant ladite deuxième surface de contact. Il va de soi que dans des applications particulières l'ensemble fonctionnel de micromécanique de l'invention, une pièce peut venir en contact de frottement avec deux ou plusieurs autres pièces. Dans ce cas, les surfaces de frottement des pièces venant en contact l'une avec l'autre présenteront des orientations des plans cristallins, différentes l'une de l'autre conformément à l'invention.

Les couches de la présente invention sont avantageusement formées par la technologie CVD à filament chaud ou par la technologie micro-onde. Le diamant peut aussi être massif, issu ou non d'une croissance. Les orientations souhaitées des plans cristallins (par exemple (100) et (111)) sont obtenues en faisant notamment varier les proportions de gaz réactifs dans l'enceinte de dépôt ainsi que les paramètres de pressions et températures comme cela est par exemple décrit dans la publication de Y. Avigal et al intitulée « [100]- Textured diamond films for tribological applications » publiée chez Elsevier dans la revue Diamond and Related Materials, vol. 6 1997, pages 381- 385 notamment § 3.1, dans la publication de Qijin Chen et al intitulée « Oriented and textured growth of (111) diamond on silicon using hot filament chemical vapor deposition » publiée chez Elsevier dans la revue Thin Solid Films vol. 274 1996 pages 160 - 164 et dans la publicaton de M. Grujjicic and S.G. Lai publiée dans le Journal of Materials Synthesis and Processing, Vol. No 2 , 200 pages 73 - 85 ces documents étant incorporés ici par référence

### DESCRIPTION DES FIGURES

D'autres caractéristiques et avantages de l'ensemble fonctionnel de micromécanique selon l'invention ressortiront également de la description détaillée suivante de modes de réalisation de cet ensemble, cette description étant effectuée à l'aide des dessins annexés, donnés à titre d'exemples nullement limitatifs et dans lesquels :
- la figure 1 est une représentation schématique en vue agrandie d'un exemple de deux surfaces de contact de deux pièces micromécaniques formant un ensemble fonctionnel de micromécanique et présentant respectivement des orientations de plans cristallins (111) et (100) selon l'invention;
- la figure 2 est une représentation schématique en vue agrandie de la surface de contact d'une des pièces micromécaniques de la figure 1 qui présente une orientation selon la direction [100] et illustrant l'angle de tilt de chacun des plans cristallins (100) ;
- la figure 3 est une vue partielle de coté d'une palette présentant un plan de repos A et un plan d'impulsion B coopérant avec les plans de repos C et d'impulsion D d'une roue d'échappement, les plans A et B définissant la première surface de contact et les plans C et D définissant la deuxième surface de contact selon l'invention ; et
- la figure 4 est une vue de dessus d'une lame de ressort de barillet présentant une face avant et une face arrière définissant respectivement les première et deuxième surfaces de contact selon l'invention ;

### DESCRIPTION DETAILLEE DE L'INVENTION

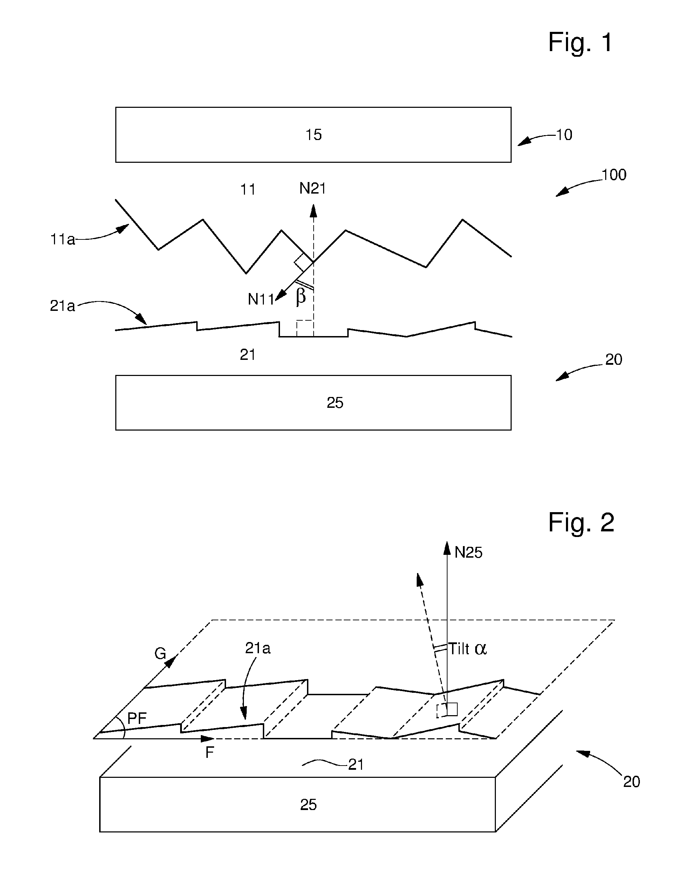

La figure 1 illustre un exemple de mode de réalisation d'un couple de pièces micromécaniques 10 et 20 selon l'invention. La première pièce 10 comporte un substrat 15 sur lequel est déposée une couche de diamant 11 présentant une surface de contact 11 a destinée à venir en contact de frottement avec une deuxième surface de contact 21a définie par une deuxième couche 21. La couche 11 présente au niveau de la surface de contact 11a des plans cristallins orientés selon une direction prédéterminée à savoir la direction [111]. Au moins au niveau de la surface de contact 11 a, la couche 11 est microcristalline, avec des tailles de grains supérieures à 200nm et une rugosité Rms supérieure à 80nm.

La pièce micromécanique 20 comporte un substrat 25 sur lequel est déposée la couche de diamant 21 présentant une surface de contact 21 a en opposition à la surface 11 a de la pièce micromécanique 10. Les couches 11 et 21 forment ainsi des couches frottement.

Au moins au niveau de la surface de contact 21 a la couche 21 présente ses plans cristallins orientés selon une direction prédéterminée à savoir la direction [100]. En pratique ces plans cristallins sont sensiblement inclinés par rapport à la direction de frottement F en raison de défauts de croissance inéluctables propres au procédé conventionnel d'obtention de la couche 21. Au moins au niveau de la surface de contact 21 a, la couche 21 est microcristalline, et présente des tailles de grains supérieures à 200nm.

Au moins au niveau des surfaces de contact 11a et 21 a destinées à venir en contact de frottement l'une avec l'autre les couches 11 et 21 présentent donc des orientations de plans cristallins différentes et dans cet exemple, ces deux orientations sont selon les directions [100] et [111]. En se référant à la figure 1 on voit qu'il est aussi possible de définir la différence d'orientation des plans cristallins des surfaces 11a et 21a par l'angle β qui est l'angle moyen formé par les normales N11 et N21 aux plans cristallins des surfaces de contact 11a et 21 a β est compris entre 10° et 70°, de préférence entre 40° et 50° et plus préférentiellement égale à 45°. L'angle ß_{moy} correspond à la moyenne des différences angulaires d'orientations cristallines β des deux surfaces de contact 11a et 21 a. Cet angle est facilement calculable par l'homme du métier du diamant car il s'agit là d'un critère important dans la maîtrise du procédé de dépôt de diamant.

La figure 2 montre à nouveau la pièce micromécanique 20, considérée isolément, de façon à pouvoir illustrer l'angle de « tilt » α. Cet angle est mesuré entre la normale locale à la surface 21 a d'une part et d'autre part à la normale NF au plan théorique de frottement PF (en pointillé sur la figure) qui est défini par la direction de frottement F et une droite G appartenant à la surface théorique définissant la surface 21 a.

L'angle α est calculé par rapport au plan théorique de frottement PF. Il représente la moyenne des angles αᵢ entre la normale N25 et la normale aux plans (100) N21 à la figure 2. L'angle α_{moy} est de préférence inférieur à 30°, et plus préférentiellement inférieur à 10°.

Typiquement les couches 11 et 21 présentent une épaisseur d'au moins 150nm et de préférence d'environ 2,5 micromètres afin d'obtenir des orientations de plans cristallins homogènes.

Plus généralement les couches 11 et 21 définissant les surfaces 11a et 21 a comportent chacune du carbone à hauteur d'au moins 50% d'atomes de carbone. Par exemple, ces couches peuvent être formées de diamant, de DLC (Diamond Like Carbon) de graphite ou d'une combinaison de ces matériaux

Selon une variante de réalisation non représentée les surfaces 11a et/ou 21 a sont recouvertes au moins partiellement d'une couche de couverture d'un autre matériau que celui constituant les couches 11 et/ou 21. Ces couches de couverture pourront par exemple être formées d'un film d'or, de nickel ou de titane. Ces couches de couverture ne devront de préférence pas présenter une épaisseur supérieure à 100nm. Dans ce cas, la texture superficielle des première et deuxième surfaces de contact présente avantageusement les orientations des plans cristallins en surface, différentes l'une de l'autre conforme à l'invention.

Les couches 11 et 21 des pièces micromécaniques 10 et 20 sont déposables sur des substrats réalisés en tous types de matériaux adaptés au dépôt de couche de diamant, de DLC (Diamond Like Carbon), ou de graphite. Par exemple les substrats 15 et 25 pourront être choisis parmi l'ensemble de matériaux comprenant les céramiques, le silicium, le silicium désoxydé, le silicium oxydé, le silicium nitruré, le silicium carburé et les aciers.

La réalisation des surfaces de contact 11a et 21 a de l'invention peut être également envisagée sans utiliser de substrat pour l'une et/ou l'autre des pièces micromécaniques. En effet les surfaces 11a et/ou 21 a peuvent selon une variante de l'invention être issues de diamant massif monocristallin ou polycristallin.

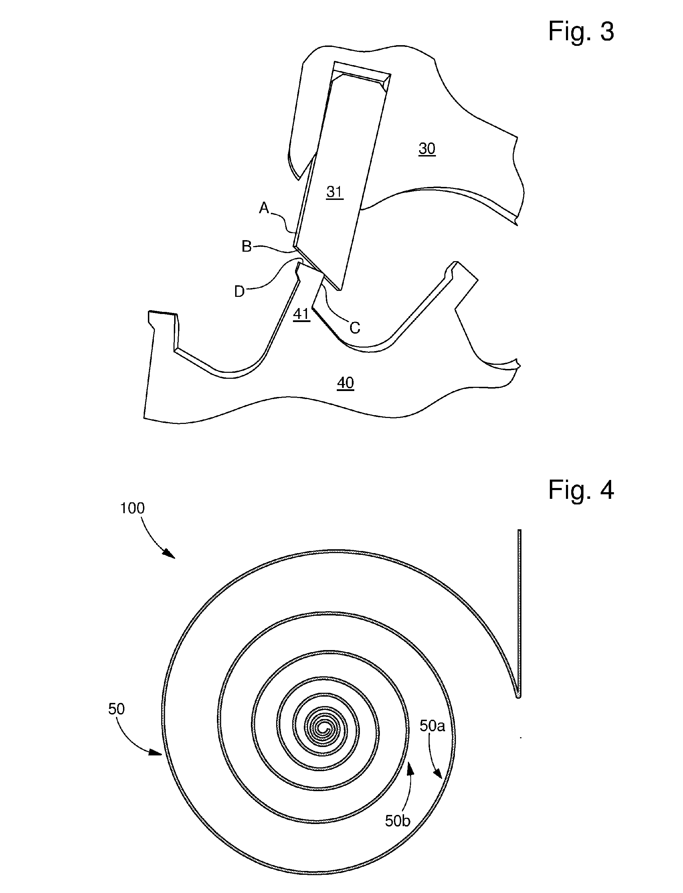

La figure 3 montre un exemple d'application de l'invention à la réalisation d'un échappement horloger dans lequel une ancre 30 comprend une palette 31 qui coopère avec une dent 41 d'une roue d'échappement 40. La palette 31 présente un plan de repos A et un plan d'impulsion B qui coopèrent avec les plans de repos C et d'impulsion D de la dent 41. Les plans de repos A et d'impulsion B présentent par exemple une surface de contact conforme à la surface 11a et les plans C et D présentent alors une surface de contact conforme à la surface 21a respectivement décrites en liaison avec les figures 1 et 2. Ces plans A, B, C, D correspondent à des zones fortement sollicitées et sujettes à des niveaux élevés de frottement et/ou contact. Selon une variante, l'ancre 30 peut venir de matière avec la palette 31.

A la figure 4, on voit une autre application horlogère de l'invention dans laquelle une lame 50 de ressort de barillet présente une face avant 50a et une face arrière 50b qui sont respectivement conformes aux surfaces de contact 11a et 21 a décrites en liaison avec les figures 1 et 2.

Néanmoins, il est évident pour un homme du métier que l'invention peut être étendue à d'autres modes de réalisation non représentés dans lesquels par exemple, les pièces micromécaniques 10 et 11 sont constituées d'un axe de mobile tel qu'un pivot et d'un palier telle qu'une pierre ou d'un couple de dentures de roues d'engrenage, ou tout autre couple d'éléments fortement sujets à d'intenses sollicitations mécaniques de nature tribologique ou pas.

Les signes de références dans les revendications n'ont aucun caractère limitatif. Les verbes "comprendre" et "comporter" n'excluent pas la présence d'autres éléments que ceux listés dans les revendications. Le mot "un" précédant un élément n'exclut pas la présence d'une pluralité de tels éléments.

## Revendications

1. Ensemble fonctionnel (100) de micromécanique comprenant au moins une première pièce (10) ayant une première couche (11) définissant une première surface de contact (11a) destinée à venir en contact de frottement avec une deuxième surface de contact (21 a) définie par une deuxième couche (21), ladite deuxième couche appartenant, soit à ladite première pièce (10) soit à au moins une deuxième pièce de micromécanique (20) constituant avec ladite première pièce (10) ledit ensemble (100) **caractérisé en ce que** les première et deuxième couches (11, 21) comportent chacune du carbone à hauteur d'au moins 50% d'atomes de carbone et **en ce qu'**elles présentent au moins au niveau des première et deuxième surfaces de contact (11a, 21 a) des orientations de plans cristallins en surface différentes l'une de l'autre.

2. Ensemble fonctionnel de micromécanique selon la revendication 1, **caractérisé en ce qu'**au moins ladite première couche (11) présente une structure microcristalline au moins au niveau de la première surface de contact.

3. Ensemble fonctionnel de micromécanique selon la revendication 2, **caractérisé en ce que** lesdites première et deuxième couches (11, 21) présentent chacune une structure microcristalline au moins au niveau de leur surface de contact respective.

4. Ensemble fonctionnel de micromécanique selon l'une des revendications précédentes, **caractérisé en ce que** les plans cristallins d'au moins ladite première couche présentent, au moins au niveau de la première surface de contact, une orientation selon une direction prédéterminée.

5. Ensemble fonctionnel de micromécanique selon la revendication 4, **caractérisé en ce que** les plans cristallins desdites première et deuxième couches présentent, au moins au niveau de leur surface de contact respective, chacune des orientations différentes selon des directions prédéterminées.

6. Ensemble fonctionnel de micromécanique selon l'une des revendications précédentes, **caractérisé en ce que** les plans cristallins d'au moins ladite première couche appartenant à la famille de plans {100} au moins au niveau de la première surface de contact.

7. Ensemble fonctionnel de micromécanique selon l'une des revendications 1 à 5, **caractérisé en ce que** les plans cristallins d'au moins ladite première couche appartenant à la famille des plans {111} au moins au niveau de la première surface de contact.

8. Ensemble fonctionnel de micromécanique selon l'une des revendications 1 à 4, **caractérisé en ce que** un des plans cristallins de la famille des plans cristallins {100} de ladite première couche au moins au niveau de la première surface de contact et un des plans cristallins de la famille des plans cristallins {111} de ladite deuxième couche au moins au niveau de la deuxième surface de contact.

9. Ensemble fonctionnel de micromécanique selon la revendication 8, **caractérisé en ce que** l'angle moyen défini par les normales aux plans cristallins (100) de la famille {100} et (111) de la famille {111} des couches au moins au niveau de leur surface de contact respective est compris entre 10° et 70°, de préférence entre 40° et 50°, et plus préférentiellement de 45°.

10. Ensemble fonctionnel de micromécanique selon l'une quelconque des revendications précédentes, **caractérisée en ce que** la taille des grains d'au moins ladite première couche (11) est supérieure à 200nm au moins au niveau de la première surface de contact.

11. Ensemble fonctionnel de micromécanique selon l'une quelconque de revendications 1 à 9, **caractérisé en ce que** la taille des grains desdites première et deuxième couches (11) est supérieure à 200nm au moins au niveau de leur surface de contact respective.

12. Ensemble fonctionnel de micromécanique selon l'une quelconque des revendications précédentes, **caractérisé en ce qu'**au moins l'une des premiers ou deuxième couches est recouverte au moins partiellement d'une couche de couverture d'un autre matériau.

13. Ensemble fonctionnel de micromécanique selon la revendication 12, **caractérisé en ce que** la couche de couverture est inférieure à 100 nm.

14. Ensemble fonctionnel de micromécanique selon l'une quelconque des revendications précédentes, **caractérisé en ce que** ladite deuxième couche appartient à ladite deuxième pièce (20) et **en ce que** la première et/ou la deuxième pièce sont réalisées en diamant massif mono ou polycristallin.

15. Ensemble fonctionnel de micromécanique selon l'une quelconque des revendications précédentes, **caractérisé en ce que** la rugosité moyenne (Rₘₛ) d'une des première ou deuxième surfaces de contact est supérieure à 80 nm.

16. Ensemble fonctionnel de micromécanique selon l'une quelconque des revendications 1 à 15 lorsqu'elle ne dépend pas de la 14, **caractérisé en ce que** ladite première et/ou deuxième couche définissant ladite première surface de contact et/ou ladite deuxième surface de contact recouvre un premier substrat pour former ladite première pièce

17. Ensemble fonctionnel de micromécanique selon l'une quelconque des revendications 1 à 15 lorsqu'elle ne dépend pas de la 14, **caractérisé en ce que** ladite deuxième couche appartient à ladite deuxième pièce (20) et **en ce que** ladite première et/ou deuxième couche définissant ladite première surface de contact et/ou ladite deuxième surface de contact recouvre un premier substrat et/ou un deuxième substrat pour former ladite première et/ou ladite deuxième pièce.

18. Ensemble fonctionnel de micromécanique selon la revendication 16 ou 17, **caractérisé en ce que** le premier et/ou le deuxième substrat est constitué de silicium ou d'acier ou de céramique.

19. Ensemble fonctionnel de micromécanique selon l'une des revendications 16 à 18, **caractérisé en ce que** ladite première et/ou deuxième couche de frottement présentent une épaisseur d'au moins 150nm.

20. Ensemble fonctionnel de micromécanique selon l'une quelconque des revendications 1 à 19, **caractérisé en ce que** ladite deuxième couche appartient à ladite deuxième pièce (20) et **en ce que** la première pièce est une palette (30) et **en ce que** la deuxième pièce est une roue d'échappement (40) ou inversement.

21. Ensemble fonctionnel de micromécanique selon l'une quelconque des revendications 1 à 19, **caractérisé en ce que** ladite deuxième couche appartient à ladite deuxième pièce (20) et **en ce que** la première pièce est un axe d'un mobile et **en ce que** la deuxième pièce est un palier ou inversement.

22. Ensemble fonctionnel de micromécanique selon l'une quelconque des revendications 1 à 19 **caractérisé en ce que** ladite deuxième couche appartient à ladite deuxième pièce (20) et **en ce que** lesdites première et deuxième pièces sont des dentures de roues d'engrenage.

23. Ensemble fonctionnel de micromécanique selon l'une quelconque des revendications 1 à 18, **caractérisé en ce que** ladite deuxième couche appartient à ladite première pièce (10) et **en ce que** la première pièce est un ressort de barillet formée d'une lame et **en ce qu'**une face avant de ladite lame forme ladite première surface de contact et **en ce que** la face arrière de la dite lame forme ladite deuxième surface de contact.
